# EUROPEAN PATENT APPLICATION

(11) **EP 4 700 820 A1**
(43) Date of publication of application: **25.02.2026**
(21) Application number: 24195161.5
(22) Date of filing: 19.08.2024
(51) Int. Cl.: H01L 21/02, H01L 21/18

(54) **COMPOUND SEMICONDUCTOR LAYERED STRUCTURE AND PROCESSES FOR PREPARING A COMPOUND SEMICONDUCTOR LAYERED STRUCTURE**

(71) Applicant: Umicore, 1000 Brussels (BE)
(72) Inventor: SCHMID, Ulrich, 1040 Vienna (AT); PFUSTERSCHMIED, Georg, 1040 Vienna (AT); PARMAR, Priyank, 1040 Vienna (AT)
(74) Representative: Umicore RDI Patent Department

(57) **Abstract**

The present invention provides a process for preparing a compound semiconductor layered structure, comprising the steps of: i. forming a layered structure (1, pre-3, 2) comprising a silicon carbide substrate (1), a silicon carbide film (2) and a bonding film (pre-3) connecting said silicon carbide substrate (1) and said silicon carbide film (2), whereby said bonding film (pre-3) comprises a ceramic-forming polymer precursor and a radical initiator; ii. curing said ceramic-forming polymer precursor by heating said layered structure (1, pre-3, 2) at a curing temperature between 100°C and 700°C, thereby forming a cured layered structure (1, 3, 2); and subsequently iii. annealing said cured layered structure (1, 3, 2) at an annealing temperature between 1180°C and 1800°C, thereby obtaining a compound semiconductor layered structure.

## Description

### TECHNICAL FIELD

The present invention relates to novel substrates for preparing compound semiconductor devices and methods for making the same. Specifically, the present invention relates to silicon carbide semiconductors.

### INTRODUCTION

Silicon carbide emerges as a most promising alternative to silicon as semiconductor material, especially for power electronic devices. This is due to its unique material properties, such as wide electronic bandgap and high thermal conductivity. However, in spite of tremendous progress, over the last decades, in both material quality and device manufacturing, widespread adoption is still hampered by the high cost of monocrystalline silicon carbide substrates. The main factors contributing to that high cost are the crystal growth process, the subsequent ingot or boule slicing and the polishing of the substrates.

To avoid energy and material intensive processes, new methods were developed whereby thin layered semiconductor structures are formed and deposited on a support. Hence, much attention has been devoted to developing techniques for forming thin layered semiconductor structures. In this respect, Leitgeb, M. et al. J. Electrochem. Soc. 2017, 164 (12), E337, described novel methods for preparing porous 4H-SiC layers from monocrystalline samples applying photo-electrochemical etching in hydrofluoric acid. It was found that the resulting degree of porosity, the homogeneity in porosity as well as the pore morphology mainly depend on the applied voltage. Importantly, the approach allowed to detach the porous 4H-SiC layers, which comprised several sub-layers of alternating degree of porosity, from the 4H-SiC substrate.

Beside prior art related to the fabrication details of the invention, alternative routes for the detachment of a thin layer from a SiC substrate, and eventual subsequent bonding onto another substrate, are described in literature. In those approaches a line of breakage is created underneath the surface of the mother substrate by utilizing ion implantation. The generated line of breakage allows the mechanical separation of a thin layer from the mother substrate which can subsequently transferred to a substrate. Alternatively, new experimental procedures allow for controlled spalling of a thin semiconductor layer from a substrate by creating a line of breakage underneath the surface of the mother substrate through inducing a mechanical stress via a stressor layer. Such a technique is reported e.g. by Bedell et al. J. Appl. Phys. 122, 2017, 025103; https://doi.org/10.1063/1.4986646.

Present methods still rely on the use of a series of multiple, complex processing steps. As such they have poor materials economy and a nonnegligible environmental impact.

US 2017/033 010 and US 2017/033 011 disclose a method for forming a semiconductor device comprising the step of forming a stack comprising the carrier wafer, the donor wafer and a bonding layer comprising the ceramic-forming polymer precursor, and tempering the stack at a temperature between 200°C to 700°C, whereby the ceramic-forming polymer precursor comprises a polycarbosilane. The donor wafer is prepared via proton implantation and is nonporous.

As exemplified from US 2017/033 010 and US 2017/033 011, processes for forming a semiconductor film suitable for layer transfer purposes are generally formed via ion implantation. Ion implantation, however, propagates amorphization of the surface of the donor wafer, i.e., the donor surface is locally destroyed with the inevitable loss of crystallinity. Such loss of crystallinity is detrimental as the surface of the donor wafer forms the surface onto which epitaxial growth of the monocrystal is envisaged. To restore surface crystallinity the amorphized surface must first be polished or recrystallized through an additional annealing step.

WO 2024/047 097 discloses a process for preparing a compound semiconductor layered structure, comprising the steps of: i. forming a layered structure comprising a silicon carbide substrate, a silicon carbide film and a bonding film connecting said silicon carbide substrate and said silicon carbide film, whereby said bonding film comprises a ceramic-forming polymer precursor; and ii. subjecting said layered structure to a curing treatment and an annealing treatment; whereby said silicon carbide film is a porous, monocrystalline film. The disclosed methods allowed for producing monocrystalline semiconductors with economical use of starting materials, energy-efficiency and flexibility in production, reduction of the production cost, improvement of energy footprint and reduction of waste material.

The present invention aims to provide new methods for producing monocrystalline semiconductors according to the methods described in WO 2024/047 097, whereby the methods are improved for enhancing bonding quality of the semiconductor multilayer.

### SUMMARY

The current invention provides a solution for at least one of the above-mentioned problems by providing a compound semiconductor layered structure and processes for preparing a compound semiconductor layered structure.

In a first aspect, the present invention provides a process for preparing a compound semiconductor layered structure, comprising the steps of:
i. forming a layered structure (1, pre-3, 2) comprising a silicon carbide substrate (1), a silicon carbide film (2) and a bonding film (pre-3) connecting said silicon carbide substrate (1) and said silicon carbide film (2), whereby said bonding film (pre-3) comprises a ceramic-forming polymer precursor and a radical initiator;
ii. curing said ceramic-forming polymer precursor by heating said layered structure (1, pre-3, 2) at a curing temperature between 100°C and 700°C, thereby forming a cured layered structure (1, 3, 2); and subsequently
iii. annealing said cured layered structure (1, 3, 2) at an annealing temperature between 1180°C and 1800°C, thereby obtaining a compound semiconductor layered structure.

Specifically, processes according to the invention are characterized in that said layered structure (1, pre-3, 2) is heated in step ii. from a temperature below 200°C to the curing temperature at a heating rate lower than 10°C per minute. The inventors have found that improved bonding layers can be formed by meticulously fine-tuning the rate of heating of layered structure (1, pre-3, 2), thereby controlling the formation of the bonding layer (3) and securing the absence of cavities or voids due to the controlled outgassing of polymerization by-products.

### DESCRIPTION OF THE FIGURES

By means of further guidance, figures are included to better appreciate the teaching of the present invention. Said figures are intended to assist the description of the invention and are nowhere intended as a limitation of the presently disclosed invention.

The figures and symbols contained therein have the meaning as commonly understood by one of ordinary skill in the art to which this invention belongs.
Figure 1 shows a process according to the present invention, whereby a monocrystalline film (2) having a porous bottom layer (pre-21), a porous core (22) and a porous top layer (pre-23) is heated, resulting in a compactification of the bottom and top layer; followed by forming a layered structure with a bonding layer (pre-3) and a substrate; and curing and annealing said layered structure.
Figure 2 shows a process according to the present invention, whereby a monocrystalline film (2) having a porous bottom layer (21), a porous core (22) and a porous top layer (23) is layered onto a substrate (1), whereby said film and said substrate are connected through a bonding layer (pre-3).
Figure 3 schematically shows an embodiment according to the invention, whereby the porous bottom and porous top layer are partially densified or compactified to afford a structure having a porous core (22), a porous bottom layer (21-p) and a porous top layer (23-p), a nonporous or compactified bottom layer (21-c) and a nonporous or compactified top layer (23-c).
Figure 4 schematically shows a compound semiconductor layered structure obtained according to the inventive process, said structure further comprising an epitaxially-grown semiconductor layer, also referred to as an overlayer (4).
Figure 5 schematically shows the temperature profile of the curing and annealing step of: (a) the bonding method according to the prior art, i.e. WO 2024/047 097 A1; and (b) the bonding method according to the present invention, respectively.
Figure 6 shows a SEM (scanning electron microscope) cross section of a bonding layer (3) resulting from: (a) the bonding method according to the prior art, i.e. WO 2024/047 097 A1; and (b) the bonding method according to the present invention, respectively.

### DETAILED DESCRIPTION OF THE INVENTION

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention.

As used herein, the following terms have the following meanings:
"A", "an", and "the" as used herein refers to both singular and plural referents unless the context clearly dictates otherwise. By way of example, "a compartment" refers to one or more than one compartment.
"About" as used herein referring to a measurable value such as a parameter, an amount, a temporal duration, and the like, is considered synonymous to the term "substantially" and is meant to encompass variations of +/-20% or less, preferably +/-10% or less, more preferably +/-5% or less, even more preferably +/-1% or less, and still more preferably +/-0.1% or less of and from the specified value, in so far such variations are appropriate to perform in the disclosed invention. However, it is to be understood that the value to which the modifier "about" refers is itself also specifically disclosed.
"Comprise," "comprising," and "comprises" and "comprised of" as used herein are synonymous with "include", "including", "includes" or "contain", "containing", "contains" and are inclusive or open-ended terms that specifies the presence of what follows e.g. component and do not exclude or preclude the presence of additional, non-recited components, features, element, members, steps, known in the art or disclosed therein.

The recitation of numerical ranges by endpoints includes all numbers and fractions subsumed within that range, as well as the recited endpoints. All percentages are to be understood as percentage by weight, abbreviated as "wt.%" or as volume per cent, abbreviated as "vol.%", unless otherwise defined or unless a different meaning is obvious to the person skilled in the art from its use and in the context wherein it is used.

The term "semiconductor" refers to any solid substance that has an electrical conductivity between that of an insulator and that of most metals. An example semiconductor layer is composed of silicon. The semiconductor layer may include a single bulk wafer, or multiple sublayers. Specifically, a semiconductor layer and more preferably a silicon carbide semiconductor layer may include multiple non-continuous porous portions. The multiple non-continuous porous portions may have different densities and may be horizontally distributed or vertically layered. Examples of semiconductor materials include, without limitation, silicon carbide, gallium-arsenide and indium-phosphide.

In the context of the present invention, a compound semiconductor is a semiconductor composed of chemical elements of at least two different species, such as Group III and V elements and Group II and VI elements. These semiconductors typically form in periodic table groups 13-15 (old groups III-V), for example of elements from the Boron group (old group III, boron, aluminium, gallium, indium) and from group 15 (old group V, nitrogen, phosphorus, arsenic, antimony, bismuth). The range of possible formulae is quite broad because these elements can form binary (two elements, e.g. gallium (III) arsenide (GaAs)), ternary (three elements, e.g. indium gallium arsenide (InGaAs)) and quaternary (four elements, e.g. aluminium gallium indium phosphide (AlInGaP)) alloys. GaAs, InP and InGaAlP are used for their application for high-frequency devices and optoelectronic devices. SiC and GaN compound semiconductors are often employed for power semiconductors. Typical compound semiconductors are:
Group II-VI: ZnSe
Group III-V: GaAs, GaN, InP, InGaAlP, InGaN
Group IV-IV: SiC, SiGe

In the context of the present invention, the term "substrate" or "semiconductor substrate" refers to a material consisting of a semiconductor material, specifically of a compound semiconductor material and more specifically silicon carbide, onto which deposited layers of a material may be formed or applied. Preferably, the substrate is a single-crystalline substrate. Said semiconductor substrate may also be referred to as a slice, a substrate or a wafer and are known to the person skilled in the art. Such semiconductor substrates are typically used as a substrate onto which microelectronic devices can be built. Semiconductor substrates may be subjected to different processes such as doping, ion implantation, etching, thin-film deposition or lithographic patterning. Exemplary substrates include, without limitation: bulk germanium wafers, bulk silicon wafers, in which a wafer comprises a homogeneous thickness of single-crystal silicon or germanium; composite semiconductor wafers comprising a homogeneous thickness of a mono- or polycrystalline compound semiconductor material; composite wafers, such as a silicon-on-insulator wafer that comprises a layer of silicon that is disposed on a layer of silicon dioxide that is disposed on a bulk silicon handle wafer; or the porous germanium, germanium over oxide and silicon, germanium over silicon, patterned germanium, germanium tin over germanium, and/or the like; or any other material that serves as base layer upon which, or in which, devices are formed. Preferably, said semiconductor substrate comprises silicon carbide. More preferably, said semiconductor substrate consists essentially of silicon carbide. A substrate may have a single bulk wafer, or multiple sublayers. Specifically, a substrate (e.g., silicon, germanium, etc.) may include multiple non-continuous porous portions. The multiple non-continuous porous portions may have different densities and may be horizontally distributed or vertically layered. In the context of the present invention, the term "substrate" generally refers to a material having a thickness of at least 1 µm. Semiconductor substrates generally have a cylindrical form whereby the diameter of said cylinder is referred to as the wafer size and the height of said cylinder is referred to as the wafer thickness. Semiconductor substrates as used in the context of the present invention may have a wafer size of 1-inch (25 mm) and having a thickness of typically around 275 µm; a wafer size of 2-inch (51 mm) and having a thickness of typically around 275 µm; a wafer size of 3-inch (76 mm) and having a thickness of typically around 375 µm; a wafer size of 4-inch (100 mm) and having a thickness of typically around 525 µm; a wafer size of 5-inch (125 mm) and having a thickness of typically around 625 µm; a wafer size of 6-inch (150 mm) and having a thickness of typically around 675 µm; a wafer size of 8-inch (200 mm) and having a thickness of typically around 725 µm; a wafer size of 12-inch (300 mm) and having a thickness of typically around 775 µm.

In the context of the present invention, the term "film" or "semiconductor film" refers to a semiconductor material having a substantially-uniform thickness of a material covering a surface. A film can have a porous or a nonporous structure. In the context of the present invention, the term "film" refers to a material having a thickness of 0.01 µm to 50 µm.

In the context of the present invention, the term "layer" or "semiconductor layer" refers to a semiconductor material having a substantially-uniform thickness of a material covering a surface. A layer can be either continuous or discontinuous (i.e., having gaps between regions of the material). For example, a layer can completely or partially cover a surface, or be segmented into discrete regions, which collectively define the layer (i.e., regions formed using selective-area epitaxy). Furthermore, a layer can have a porous or a nonporous structure. In the context of the present invention, the term "layer" refers to a material having a thickness of at least 0.1 µm and at most 800 µm. Also, in the context of the present invention, the term "core" is to be understood as synonymous to the term "core layer."

A first layer or a first film described and/or depicted herein as "configured on," "deposited on," "on top of," "on" or "over" a second layer or a second film can be immediately adjacent to the second layer, or one or more intervening layers can be between the first and second layers. In a preferred embodiment of the invention, said first layer or a first film is in direct contact with or bonded with or directly to said second layer or said second film. In the context of the present invention, the term "disposed on" means "exists on" an underlying material or layer. This layer may comprise intermediate layers, such as transitional layers, necessary to ensure a suitable surface. For example, if a material is described to be "disposed on a substrate," this can mean either that the material is in intimate contact with the substrate; or that the material is in contact with one or more transitional layers that reside on the substrate.

In the context of the present invention, the term "in direct contact with" is synonymous for the terms "adhered directly to," "bonded directly to," "in direct contact with" and is to be understood as two distinct layers which may have the same composition, crystallinity, porosity but which are distinguishable, e.g. from cross-sectional SEM image analysis, by layer boundaries, whereby said two distinct layers are connected to each other or bonded to each other without use of a bonding agent such as an organic or inorganic gluing agent.

In the context of the present invention, the porosity of a material is expressed as volume percent, abbreviated as "vol.%" or as "%." In the context of the present invention, the porosity of a layer or a film can be determined by SEM analysis of said layer or film during multiple stages of an electrochemical etching process. SEM image analysis of a layer or film is obtained by etching with an electrolyte solution comprising 150 ml of 48 wt.% HF, 150 ml ethanol and 1200 ml deionized water in an etching chamber from AMMT GmbH for porous silicon etching and using a 250 Watt mercury arc lamp for front side illumination. The electrochemical etching process parameters used are (i) for C-face: 1 min 11.5V applied, 6 min 8.5 V applied, 1 min 11.5 V applied, 0.05 min 60 V applied for foil release from the substrate; and (ii) Si-face: 1 min 11.5V applied, 9 min 8.5 V applied, 1 min 11.5 V applied, 0.05 min 60 V applied for foil release from the substrate. The degree of porosity is analysed with an OpenCV image analysis library, using denoising and adaptive Gaussian image thresholding to determine the degree of porosity. In the context of the present invention, the term "porous" refers to a layer or film comprising pores, whereby the void volume of said layer or film is at least 1 vol.% of the total volume of said layer or film. Typically, the void volume of a porous layer is up to 30%, 40%, 50%, 60%, or even up to 70%. In the context of the present invention, the term "nonporous" refers to a layer or film preferably devoid of pores or a layer or film having a porosity of at most 1%, preferably at most 0.8%, more preferably at most 0.5% and most preferably 0%.

In the context of the present invention, the term "surface" refers to a two-dimensional outer face or exterior boundary of a body or part of a body, e.g. a layer; the term "surface area" refers to the size of said surface; and the term "surface layer" refers to a three-dimensional outer layer or exterior boundary of a body or part of a body, e.g. a layer. Hence, in the context of the present invention, the term 'surface' is distinguished from the term 'surface area' and from the term 'surface layer'.

Any of the structures depicted and described herein can be part of larger structures with additional layers above and/or below those depicted. For clarity, the figures herein can omit these additional layers, although these additional layers can be part of the structures disclosed. In addition, the structures depicted can be repeated in units, even if this repetition is not depicted in the figures.

The growth and/or deposition described herein may be performed using one or more of chemical vapor deposition (CVD), metalorganic chemical vapor deposition (MOCVD), organometallic vapor phase epitaxy (OMVPE), atomic layer deposition (ALD), molecular beam epitaxy (MBE), halide vapor phase epitaxy (HVPE), pulsed laser deposition (PLD), and/or physical vapor deposition (PVD).

The present invention aims to provide bonded compound semiconductor layered structures obtained from bonding a compound semiconductor thin film and a compound semiconductor substrate, especially 4H-SiC materials. One object of the invention is to provided bonded multilayers whereby the bonding layer (i.e., 3) is a continuous, homogeneous bonding layer with uniform characteristics, amongst others in terms of electrical and thermal conductivity. The inventors have achieved this object by ensuring that the formed bonding layer is devoid of voids, cavities or other irregularities such as defects, cracks, delamination, fissures or discontinuities. Therefore, in the context of the present invention, the following terms are defined specifically: A void refers to an absence of material within a structure, characterized by an empty space or gap that interrupts the continuity of the material. It is typically formed during manufacturing or as a result of material degradation. A cavity is defined as a hollow region within a solid material. It is an enclosed or partially enclosed space that may form due to manufacturing defects. A defect denotes any imperfection or irregularity within a material that deviates from the intended design or structure. Defects can include voids, cracks, inclusions, and other anomalies that affect the material's properties. A crack is an elongated fracture or separation within a material. It typically extends from the surface into the interior, caused by stress, thermal cycling, or mechanical impact, and can compromise the structural integrity of the material. A discontinuity is a general term for any interruption in the material's uniformity or continuity. This includes breaks, gaps, separations, defects, voids and cavities that alter the consistent structure of the material. In the context of the present invention, the term "void" refers any absence of material within a structure, characterized by an empty space or gap that interrupts the continuity of the material, and should be understood to encompass the terms "cavity", "defect", "crack", "discontinuity", "delamination", "interruption" and "fissure."

In a first aspect, the present invention provides a process for preparing a compound semiconductor layered structure, comprising the steps of:
i. forming a layered structure (1, pre-3, 2) comprising a silicon carbide substrate (1), a silicon carbide film (2) and a bonding film (pre-3) connecting said silicon carbide substrate (1) and said silicon carbide film (2), whereby said bonding film (pre-3) comprises a ceramic-forming polymer precursor and a radical initiator;
ii. curing said ceramic-forming polymer precursor by heating said layered structure (1, pre-3, 2) at a curing temperature between 100°C and 700°C, thereby forming a cured layered structure (1, 3, 2); and subsequently
iii. annealing said cured layered structure (1, 3, 2) at an annealing temperature between 1180°C and 1800°C, preferably between 1200°C and 1800°C and more preferably between 1250°C and 1800°C, thereby obtaining a compound semiconductor layered structure.

Once the layered structure is formed, the ceramic-forming polymer is cured. In a preferred embodiment, the present invention provides a process according to the first aspect of the invention, whereby said ceramic-forming polymer precursor is cured in presence of a radical initiator thermally at ambient temperature or by photon activation (UV). Preferably, said radical initiator comprises a nitrogen-containing radical initiator, more preferably azobisisobutyronitrile (AIBN). Utilizing a nitrogen-containing radical initiator such as AIBN as a radical initiator allows for curing of the ceramic-forming polymer precursor at a substantially lower temperature under controlled conditions. This allows for forming a mechanically stable, cured layered structure. Moreover, the use of a nitrogen-containing radical initiator such as AIBN allows to increase the content of nitrogen in the formed ceramic bonding layer, which improves electrical conductivity. In a preferred embodiment, the present invention provides a process according to the first aspect of the invention, whereby said ceramic-forming polymer precursor is contacted with said bottom layer of said silicon carbide film at a temperature between 25°C and 200°C, preferably at a temperature between 40°C and 160°C, and more preferably at a temperature between 50°C and 120°C. Pre-heating or heating the ceramic-forming polymer precursor before and/or during contacting said porous silicon carbide film allows for a lower viscosity, which allows for an improved impregnation of the ceramic-forming polymer into the pores of the bottom layer. Accordingly, a deeper impregnation can be realized more readily. However, said ceramic-forming polymer precursor should be heated to a temperature sufficiently low to avoid premature polymerization of the precursor.

In a preferred embodiment, the present invention provides a process according to the first aspect of the invention, whereby said silicon carbide film has a porous core. Such a porous core is advantageous in that volatiles formed during said curing treatment, i.e. during crosslinking, are more easily removed from the interlayer, thereby yielding better mechanical and electrical properties.

In a preferred embodiment, the present invention provides a process according to the first aspect of the invention, whereby said silicon carbide film (2) is a monocrystalline, porous silicon carbide film (2) obtained by exfoliation of a silicon carbide film from a monocrystalline silicon carbide wafer by electrochemical porosification.

A monocrystalline, porous compound semiconductor film (2) can be obtained by an electrochemical porosification technique according to the experimental procedure described in Leitgeb, M. et al. Stacked Layers of Different Porosity in 4H SiC Substrates Applying a Photoelectrochemical Approach. J. Electrochem. Soc. 2017, 164 (12), E337, https://doi.org/10.1149/2.1081712jes; Leitgeb, M. et al. Metal Assisted Photochemical Etching of 4H Silicon Carbide. J. Phys. Appl. Phys. 2017, 50 (43), 435301, https://doi.org/10.1088/1361-6463/aa8942. The skilled person will appreciate that the porosity of the exfoliated compound semiconductor film can easily be modified by variation of the electrochemical process parameters. Ensuring that the surface layer of the exfoliated semiconductor film has a higher porosity compared to the core of said semiconductor film allows for controlled and proper impregnation of the bottom layer of the exfoliated semiconductor film onto said semiconductor substrate. Preferably, said exfoliated semiconductor film (2) has a core portion having a porosity between 1% and 40%, preferably between 1% and 30%, as determined by cross-sectional SEM image analysis, preferably a porosity between 2% and 25%, and more preferably between 5% and 20%. The inventors have further found that such an electrochemical porosification procedure maintains in the remaining skeleton the crystallinity of the original semiconductor material.

According to the second embodiment of the invention, said core (22) has a porosity of 15% to 45%, as determined by SEM.

In a specific embodiment of the invention, the present invention provides a process according to the first aspect of the invention, said silicon carbide film (2) has a bottom layer (21), whereby said porous bottom layer (21) has a porosity of at most 50%, as determined by SEM image analysis. Said porous layer (21) may have a porosity of 1% to 45%, or of 5% to 45% and even of 10% to 30%, such as 10%, 15%, 20%, 25%, 30%, 35%, 40%, or 45%, or any value there in between. SEM image analysis of a porous layer (21) is obtained by etching with an electrolyte solution comprising 150 ml of 48 wt.% HF, 150 ml ethanol and 1200 ml deionized water in an etching chamber from AMMT GmbH for porous silicon etching and using a 250 Watt mercury arc lamp for front side illumination. The electrochemical etching process parameters used are (i) for C-face: 1 min 11.5V applied, 6 min 8.5 V applied, 1 min 11.5 V applied, 0.05 min 60 V applied for foil release from the substrate; and (ii) Si-face: 1 min 11.5V applied, 9 min 8.5 V applied, 1 min 11.5 V applied, 0.05 min 60 V applied for foil release from the substrate. The degree of porosity is analysed with an OpenCV image analysis library, using denoising and adaptive Gaussian image thresholding to determine the degree of porosity.

Preferably, the present invention provides a compound semiconductor layered structure according to the first aspect of the invention, wherein said semiconductor substrate and said semiconductor film comprise silicon carbide. Preferably, said silicon carbide comprises 4H-silicon carbide (4H-SiC). More preferably, said silicon carbide consists essentially of 4H-silicon carbide (4H-SiC).

Specifically, the invention provides a process as described above, whereby said layered structure (1, pre-3, 2) is heated in step ii. from a temperature below 200°C to the curing temperature at a heating rate lower than 10°C per minute, preferably at a heating rate between 1°C per minute and 10°C per minute, more preferably between 2°C per minute and 8°C per minute and even more preferably between 3°C per minute and 7°C per minute, such as about 4°C per minute, about 5°C per minute, or about 6°C per minute. The inventors have found that improved bonding layers can be formed by meticulously fine-tuning the rate of heating of layered structure (1, pre-3, 2), thereby controlling the formation of the bonding layer (3) and securing the absence of cavities or voids due to the controlled outgassing of polymerization by-products.

In a preferred embodiment, the present invention provides a process according to the first aspect of the invention, whereby said ceramic-forming polymer precursor comprises a polycarbosilane, preferably a vinyl group containing polycarbosilane. The ceramic-forming polymer precursor preferably comprises essentially carbon, silicon, and hydrogen. When the hydrogen diffuses during the bonding process, only polycarbosilane-evolved silicon carbide may remain. For example, the ceramic-forming polymer precursor may be an allyl-hydrido-polycarbosilan or another polycarbosilane.

In a preferred embodiment, the present invention provides a process according to the first aspect of the invention, whereby said curing treatment is performed at a temperature of 300°C to 600°C. In a preferred embodiment, the present invention provides a process according to the first aspect of the invention, whereby said curing treatment is performed at a temperature of about 400°C. Such temperatures have shown to be optimal for bonding of the porous silicon carbide film and crosslinking of a polycarbosilane layer.

In a preferred embodiment, the present invention provides a process according to the first aspect of the invention, whereby said curing step ii. comprises step ii.(a) whereby said layered structure (1, pre-3, 2) is heated in step ii. from a temperature below 200°C to the curing temperature at a heating rate lower than 10°C per minute, preferably at a heating rate between 1°C per minute and 10°C per minute, more preferably between 2°C per minute and 8°C per minute and even more preferably between 3°C per minute and 7°C per minute, such as about 4°C per minute, about 5°C per minute, or about 6°C per minute; and/or step ii.(b), optionally subsequent to step ii.(a), whereby the at least partially cured layered structure (1, 3, 2) is kept at a substantially constant temperature for a period of 1 minute to 8 hours, preferably for a period of 15 minutes to 4 hours and more preferably for a period of 30 minutes to 2 hours, or about 1 hour. The inventors found that layer defects may be formed by outgassing of curing by-products at temperatures between about 400°C and 900°C, and that a lower temperature heating rate and/or ensuring an intermediate period of temperature stabilization allows for reduced formation of voids. It was observed that most of the outgassing of curing by-products occurred predominantly between 450°C and about 900°C, hence in this region the heating rate is kept relatively moderate.

In a preferred embodiment, the present invention provides a process according to the first aspect of the invention, whereby said layered structure (1, pre-3, 2) is heated in step iii. from the curing temperature to about 900°C at a rate lower than 10°C per minute, preferably at a heating rate between 1°C per minute and 10°C per minute, , preferably at a rate between 1°C per minute and 9 °C per minute, more preferably between 2°C per minute and 8°C per minute and even more preferably between 3°C per minute and 7°C per minute, such as about 4°C per minute, about 5°C per minute, or about 6°C per minute.

In a preferred embodiment, the present invention provides a process according to the first aspect of the invention, whereby said bonding film (pre-3) is spin-coated onto a silicon carbide substrate (1) prior to step i. Preferably, said spin-coated bonding film (pre-3) is provided with a thickness of 50 nm to 1000 nm, as determined by SEM, preferably with a thickness of 50 nm to 500 nm, and more preferably about 100 nm to 200 nm.

In a preferred embodiment, the present invention provides a process according to the first aspect of the invention, whereby said layered structure (1, pre-3, 2) is pre-bonded prior to step ii. by applying a bonding force of 50 N to 1000 N, or of 100 N to 500 N, or of 200 N to 400 N, for a period of at least 1 minute at a temperature above 100°C. Preferably, said layered structure (1, pre-3, 2) is pre-bonded prior to step ii. by applying a bonding force and heating the layer structure to a temperature of 200°C to 700°C for a period of 1 minute to 8 hours, preferably for a period of 15 minutes to 4 hours and more preferably for a period of 30 minutes to 2 hours, or about 1 hour. This facilitates the bonding.

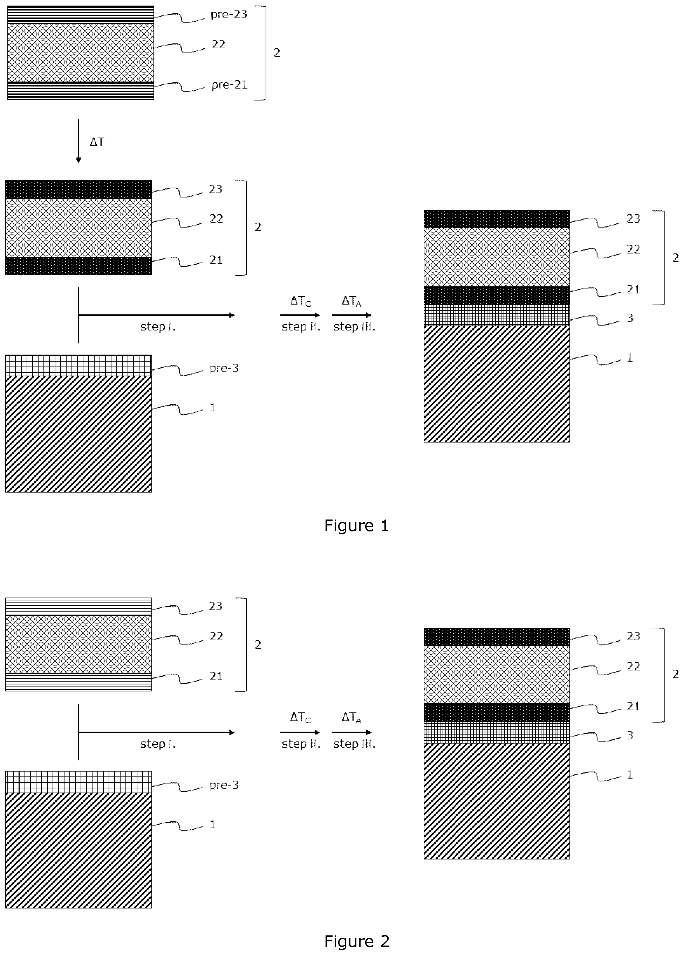

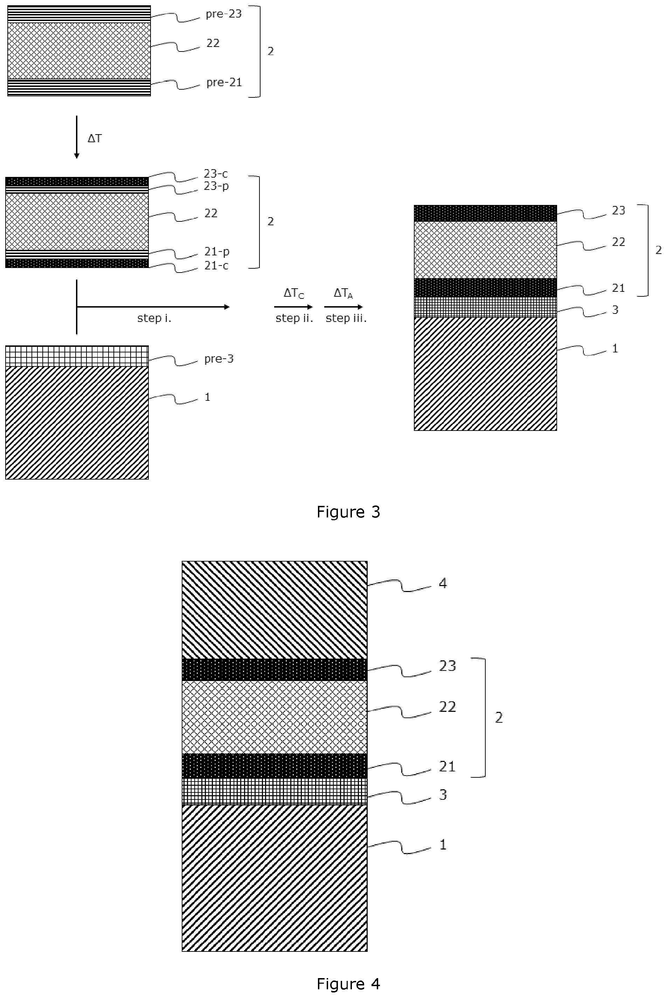

In a preferred embodiment, the present invention provides a process according to the first aspect of the invention, whereby said silicon carbide film (2) is monocrystalline and has a porous core (22) having a porosity of 1 to 40%, as determined by cross-sectional SEM image analysis. Said silicon carbide film (2) comprises a porous core (22), a bottom layer (21) and a top layer (23), opposite of said bottom layer (21). Said bottom layer (21) and said top layer (23) may be porous as schematically represented in Figure 2; or said bottom layer (21) and said top layer (23) may be nonporous as schematically represented in Figure 1. Figure 3 schematically shows an embodiment according to the invention, whereby the porous bottom and porous top layer are partially densified or compactified to afford a structure having a porous core (22), a porous bottom layer (21-p) and a porous top layer (23-p), a nonporous or compactified bottom layer (21-c) and a nonporous or compactified top layer (23-c). A nonporous bottom layer (21) and a nonporous top layer (23) may be achieved by annealing a porous monocrystalline silicon carbide film having a porous core (22), a porous bottom layer (pre-21) and a porous top layer (pre-23), whereby said porous bottom layer (pre-21) and said porous top layer (pre-23) have a high porosity, i.e., a porosity of at least 40%. The high temperature during the annealing step effects a compactification of the porous bottom layer (pre-21) and the porous top layer (pre-23), resulting in a nonporous, compactified bottom layer (21) and top layer (23), see Figure 1.

Processes according to the invention are characterized in that said silicon carbide film (2) has a monocrystalline structure. I.e., said porous core (22), said bottom layer (21) and said top layer (23) are monocrystalline in step i., ii. and iii. of the process. Processes according to the invention are characterized in that said silicon carbide film (2) has a porous core (22) having a porosity of 1 to 40%, as determined by cross-sectional SEM image analysis. Furthermore, the obtained compound semiconductor layered structure has a nonporous, monocrystalline top layer (23).

Preferably, said silicon carbide substrate (1) is a polycrystalline substrate. The approach according to the present invention allows for the silicon carbide film to maintain a monocrystalline surface throughout the entire procedure. As such, annealing of the cured ceramic-forming polymer precursor allows for improved grain growth with the formation of nanosized monocrystals. Moreover, the silicon carbide film (2) provides a monocrystalline surface layer onto which epitaxial growth can be realized. In the embodiment according to Figure 2, processes are characterized in that said silicon carbide film (2) has a bottom layer (21) having a porosity of 1 to 60%, as determined by cross-sectional SEM image analysis. The porosity of said bottom layer refers to the porosity as measured before said silicon carbide film is brought into contact with said ceramic-forming polymer precursor. It is preferred that at least 1 wt.% of said ceramic-forming polymer precursor enters the pores of said bottom layer, preferably at least 2 wt.%, at least 5 wt.% or even at least 10 wt.%. Preferably, not more than 95 wt.% of said ceramic-forming polymer precursor enters the pores of said bottom layer, more preferably not more than 80 wt.% or even not more than 60 wt.%. In step i., said bottom layer (21) is not closed and is at least partially impregnated with said ceramic-forming polymer precursor prior to subjecting said layered structure to said annealing treatment. The present invention thus also realizes a novel bonding between a silicon carbide substrate and a silicon carbide film by allowing for the impregnation of the bottom layer with the ceramic-forming polymer precursor, before polymerisation of the precursor. This allows for a better contact, and consequently also an improved bonding strength of the multilayer structure. Without limiting to mechanistic considerations, it is contemplated that the inventive process allows for both adhesive bonding and physical bonding. Due to the physical entanglement of the ceramic-forming polymer precursor and the silicon carbide film, a physical bonding is realized.

In the embodiment according to Figure 1, processes are characterized in that said silicon carbide film (2) has a nonporous bottom layer (21), as determined by cross-sectional SEM image analysis. In a preferred embodiment, the present invention provides a process according to the first aspect of the invention, whereby said silicon carbide film (2) has a nonporous top layer (23), opposite of said bottom layer (21). Preferably, the present invention provides a compound semiconductor layered structure according to the first aspect of the invention, wherein said top layer (23) of said semiconductor film is a nonporous, monocrystalline layer. In other words, said top layer (23) is impervious, dense, compact or closed. This is easily identified by SEM of a cross-section of said film. In case of a porous core (22), such top layer (23) is characterized by an enhanced density relative to the density of the porous core. Having a monocrystalline top layer (23) allows for growing monocrystalline, homoepitaxial layers directly on top of said top layer (23). In a preferred embodiment, said bottom layer (21) is closed. This is easily identified by SEM of a cross-section of said film. Preferably, said bottom layer (21) is monocrystalline. In a preferred embodiment, said top layer (23) and said bottom (21) layer are closed. Having a closed bottom layer (21) allows for good electric contact with the supporting substrate and good mechanical stability.

In a preferred embodiment, the present invention provides a process according to the first aspect of the invention, whereby said silicon carbide film (2) is obtained by subjecting a porous silicon carbide film (pre-2) to a heat treatment to allow the porous top and bottom layer to reorganize and to form a closed or nonporous surface layer. Preferably, said porous silicon carbide semiconductor film (pre-2) is subjected to a heat treatment at a temperature between 1180°C and 1800°C, preferably between 1200°C and 1800°C and more preferably between 1250°C and 1750°C, and most preferably between 1450°C and 1650°C, under a N₂ atmosphere or under an inert atmosphere, such as helium, argon or hydrogen gas. In the context of the present invention, N₂ gas and O₂ gas are not considered inert gasses. Additionally, said inert atmosphere may further comprise SiH₄ to anticipate out-diffusion of Si during said heat treatment. It is contemplated that during such heat treatment, the high porosity bottom layer and top layer of the porous film is subject to local self-diffusion at high temperature and undergoes densification at the porous surfaces of the porous film (2).

In a preferred embodiment, the present invention provides a process for preparing a compound semiconductor layered structure according to the first aspect of the invention, wherein said compound semiconductor layered structure has a diameter of 1 cm to 50 cm. More preferably, said compound semiconductor layered structure has a diameter of 5 cm to 35 cm. Most preferably, said diameter is about 100 mm or 4 inch, about 150 mm or 6 inch, about 200 mm or 8 inch, or about 300 mm or 12 inch, or any diameter there in between.

In a specific embodiment of the invention, the present invention provides a process according to the first aspect of the invention, whereby said porous bottom layer (21) has an average pore size of at most 500 nm, as determined by SEM image analysis. Preferably, said porous bottom layer (21) has an average pore size of 50 nm to 500 nm, more preferably of 100 nm to 400 nm, and even more preferably of 150 nm to 350 nm. Most preferably said porous core of said porous bottom layer (21) has an average pore size of 160 nm, 170 nm, 180 nm, 190 nm, 200 nm, 210 nm, 220 nm, 230 nm or 240 nm, or any value there in between.

Preferably, the present invention provides a process according to the first aspect of the invention, whereby, during said curing treatment, said silicon carbide substrate (1) is in direct contact with said bonding film (pre-3) comprising said ceramic-forming polymer precursor, and whereby said bonding film (pre-3) is on its opposite side in direct contact with said bottom layer (21) of said silicon carbide film (2). Preferably, the multilayer is pressed onto said semiconductor substrate (1) at a hot-press pressure of 5 MPa to 100 MPa. Such processes are easily conducted in a hot-press. Preferably, said heat treatment is performed at a hot-press pressure between 10 MPa and 75 MPa, more preferably between 15 MPa and 60 MPa, and even more preferably between 20 MPa and 50 MPa. Most preferably, said heat treatment is performed at a hot-press pressure of about 20 MPa, 25 MPa, 30 MPa, 35 MPa, 40 MPa, 45 MPa or 50 MPa, or any pressure there in between. It was found that applying a pressure during the fusion bonding process improves the bonding characteristics of the obtained semiconductor layered structure.

In a preferred embodiment, the present invention provides a process according to the first aspect of the invention, whereby said annealing treatment in step iii. is performed at a temperature between 1180°C and 1800°C, preferably between 1200°C and 1800°C and more preferably between 1250°C and 1800°C. Preferably, said annealing treatment is performed at a temperature higher than 1400°C, preferably at a temperature of 1500°C to 1600°C, more preferably at a temperature above 1550°C, such as 1560°C, 1570°C, 1580°C, 1590°C or 1600°C.

Preferably, a polycarbosilane is used which pyrolyzes at temperature of 1500°C to 1700°C to a polycrystalline silicon carbide, such as e.g., but not limited to, allyl-hydrido-polycarbosilane. As such, a quantitative conversion of the polymer to silicon carbide is realized, and the bonding layer consequently consists essentially of silicon carbide. This allows for a proper electrical conductivity, especially when an amount of suitable doping elements is included.

In a preferred embodiment, the present invention provides a process according to the first aspect of the invention, whereby said silicon carbide semiconductor substrate (1) comprises a polycrystalline material.

Preferably, the contacting surface of said silicon carbide substrate, i.e. the surface which is contacted with said silicon carbide film, has a surface roughness of at most 50 nm, as determined by Atomic Force Microscopy (AFM). A suitable AFM procedure for determining surface roughness of Si nanostructures is described by Nagase et al. Metrology of Atomic Force Microscopy for Si Nano-Structures. Jpn. J. Appl. Phys. 1995, 34, 3382, https://iopscience.iop.org/article/10.1143/JJAP.34.3382/meta. More preferably, said contacting surface of said semiconductor substrate has a surface roughness of at most 20 nm, at most 10 nm, at most 5 nm, at most 2 nm, or even at most 1 nm. Most preferably, said contacting surface has a surface roughness of about 0.9 nm, 0.8 nm, 0.7 nm, 0.6 nm, 0.5 nm, 0.4 nm, 0.3 nm, 0.2 nm, or 0.1 nm, or any value there in between. The inventors found that adhesion of the silicon carbide film to said silicon carbide substrate improves as the surface roughness of the contacting surface of said silicon carbide substrate is lower. Lower surface roughness of said contacting surface of said semiconductor substrate can be achieved by polishing, e.g. mechanical, chemo-mechanical, electrochemical or photoelectrochemical polishing.

In a preferred embodiment, the present invention provides a process according to the first aspect of the invention, whereby said bonding film (pre-3) comprising said ceramic-forming polymer precursor is provided between said silicon carbide substrate (1) and said silicon carbide film (2) with a thickness of 200 nm to 800 nm, preferably about 400 nm.

In a preferred embodiment, the present invention provides a process according to the first aspect of the invention, whereby said bottom layer (21) of said silicon carbide film (2) is provided with a thickness of at least 5 nm and at most 1000 nm, preferably at least 10 nm and at most 500 nm, and more preferably at least 20 nm and at most 100 nm.

Preferably, the present invention provides a process according to the first aspect of the invention, wherein said silicon carbide film (2) has a thickness of 0.05 to 100 µm, as determined by SEM image analysis, preferably of 0.05 to 75 µm, and more preferably of 0.05 to 50 µm. Preferably, the present invention provides a compound semiconductor layered structure according to the first aspect of the invention, wherein said silicon carbide film has a thickness of 0.05 µm to 30 µm, as determined by SEM image analysis. Preferably, said silicon carbide film has a thickness of 0.1 µm to 25 µm, more preferably of 0.5 µm to 16 µm, and even more preferably of 1 µm to 10 µm. Most preferably, said silicon carbide film has a thickness of 1 µm to 5 µm, and especially preferred is equal to 1 µm, 2 µm, 3 µm, 4 µm or 5 µm, or any value there in between. Especially preferred, said silicon carbide film has a thickness of 1 µm.

In a preferred embodiment, the present invention provides a process according to the first aspect of the invention, whereby said silicon carbide film (2) having a porous bottom layer (21) is obtained by metal-assisted photochemical etching (MAPCE) and photoelectrochemical etching (PECE). Experimental procedures for MAPCE and PECE are described in: Leitgeb, M. et al. Stacked Layers of Different Porosity in 4H SiC Substrates Applying a Photoelectrochemical Approach. J. Electrochem. Soc. 2017, 164 (12), E337, https://doi.org/10.1149/2.1081712jes; Leitgeb, M. et al. Metal Assisted Photochemical Etching of 4H Silicon Carbide. J. Phys. Appl. Phys. 2017, 50 (43), 435301, https://doi.org/10.1088/1361-6463/aa8942.

Preferably, the present invention provides a process according to the first aspect of the invention, whereby said ceramic-forming polymer precursor is spin-coated onto said bottom layer (21). Alternatively, the ceramic-forming polymer precursor may be applied by spray processes.

Preferably, the present invention provides a process according to the first aspect of the invention, whereby said curing and/or said annealing treatment is performed under an inert atmosphere or under a nitrogen atmosphere. Additionally, said inert atmosphere may further comprise SiH₄ to anticipate out-diffusion of Si during said heat treatment. In the context of the present invention, the term 'inert atmosphere' is to be understood as an atmosphere of helium, argon and/or hydrogen. In the context of the present invention, N₂ gas and O₂ gas are not considered inert gasses.

In a preferred embodiment, the present invention provides a process according to the first aspect of the invention, whereby said ceramic-forming polymer precursor comprises one or more doping elements, especially nitrogen, before said curing treatment.

Preferably, the present invention provides a compound semiconductor layered structure according to the first aspect of the invention, said compound semiconductor layered structure further comprising a semiconductor layer, also referred to as an overlayer (4), having a bottom surface and a top surface, whereby said bottom surface of said second semiconductor layer is in contact with said top layer of said semiconductor film. This is shown in Figure 4. Preferably, said bottom surface of said second semiconductor layer is in direct contact with said top layer of said semiconductor film. The use of a semiconductor film of a predetermined quality on top of a semiconductor substrate of a different quality allows for the use of more readily available materials as substrate materials. In fact, whereas the semiconductor film is mainly chosen for the purposes of easily growing a semiconductor crystal layer on top of said film, the substrate may within the concept of the present invention, be selected mainly on the basis of mechanical and cost related characteristics, next to its thermo-mechanical and electrical compatibility with the semiconductor film on top of it. Said semiconductor overlayer comprises, without limitation, one or more selected of alumina, silicon carbide, gallium-arsenide, indium-phosphide, silica, quartz, and sapphire. Preferably, said semiconductor overlayer is not an insulator. Preferably, said semiconductor overlayer comprises silicon carbide, and more preferably, said semiconductor overlayer consists essentially of silicon carbide.

In a preferred embodiment, said semiconductor layer is an epitaxially grown semiconductor layer, also referred to as an "overlayer." In the context of the present invention, this means that the semiconductor layer is grown in a type of crystal growth or material deposition process in which new crystalline layers are formed with one or more well-defined orientations with respect to the crystalline semiconductor film. The deposited crystalline semiconductor layer is called an epitaxial layer. The relative orientation(s) of the epitaxial layer to the crystalline film is defined in terms of the orientation of the crystal lattice of each material. For epitaxial growth, the new layer must be crystalline and the overlayer crystal must have a well-defined orientation relative to the film crystal structure.

In a second aspect, the present invention provides silicon carbide semiconductor layered structure obtained by a process according to the first aspect of the invention. Silicon carbide layered structures obtained by a process according to the first aspect of the invention may be identified by the presence of doping elements in the silicon carbide bonding layer (3), as determined by XPS. Doping elements may be entrained from the atmosphere, such as nitrogen, or may result from an initiator used during curing of the ceramic-forming polymer precursor.

In a third aspect, the present invention provides a silicon carbide semiconductor layered structure, comprising:
i. a silicon carbide substrate (1) having a bottom surface and a top surface;
ii. a silicon carbide film (2), said silicon carbide film (2) having a bottom layer (21), a porous core (22) and a nonporous top layer (23);
iii. a silicon carbide bonding layer (3) on a first side in direct contact with said silicon carbide substrate (1), and on a second side, opposite of the first side, in direct contact with said silicon carbide film (2).

Specifically, the present invention provides a silicon carbide semiconductor layered structure according to the third aspect of the invention, whereby said silicon carbide bonding layer (3) is free of voids having an average diameter larger than 100 nm, as determined by SEM, preferably free of voids having an average diameter larger than 50 nm, and more preferably free of voids having an average diameter larger than 10 nm. Absence of voids ensure homogeneous characteristics of the silicon carbide bonding layer (3).

In a preferred embodiment, the present invention provides a silicon carbide semiconductor layered structure according to the third aspect of the invention, whereby said silicon carbide bonding layer (3) comprises nanocrystalline β-SiC. This allows to realize an electrically conductive bonding interface.

In a preferred embodiment, the present invention provides a silicon carbide semiconductor layered structure according to the third aspect of the invention, wherein said silicon carbide bonding layer (3) has a layer thickness of between 50 nm and 1000 nm. Preferably, said polymeric silicon carbide layer (3) has a layer thickness of about 100 nm to about 500 nm, such as 100 nm, 200 nm, 300 nm, 500 nm or 500 nm.

In a preferred embodiment, the present invention provides a silicon carbide semiconductor layered structure according to the third aspect of the invention, wherein said silicon carbide bonding layer (3) comprises one or more doping elements. Preferably, said doping elements are selected from the group consisting of B, N and P. Preferably, said silicon carbide bonding layer (3) comprises nitrogen in an amount of 10¹⁹ atoms nitrogen per cm³. As such, said silicon carbide layer (3) is more electrically conductive.

In a preferred embodiment, the present invention provides a silicon carbide semiconductor layered structure according to the third aspect of the invention, whereby said silicon carbide film (2) is monocrystalline and has a porous core (22) having a porosity of 1 to 40%, as determined by cross-sectional SEM image analysis, and whereby said silicon carbide substrate (1) is polycrystalline.

### EXAMPLE 1

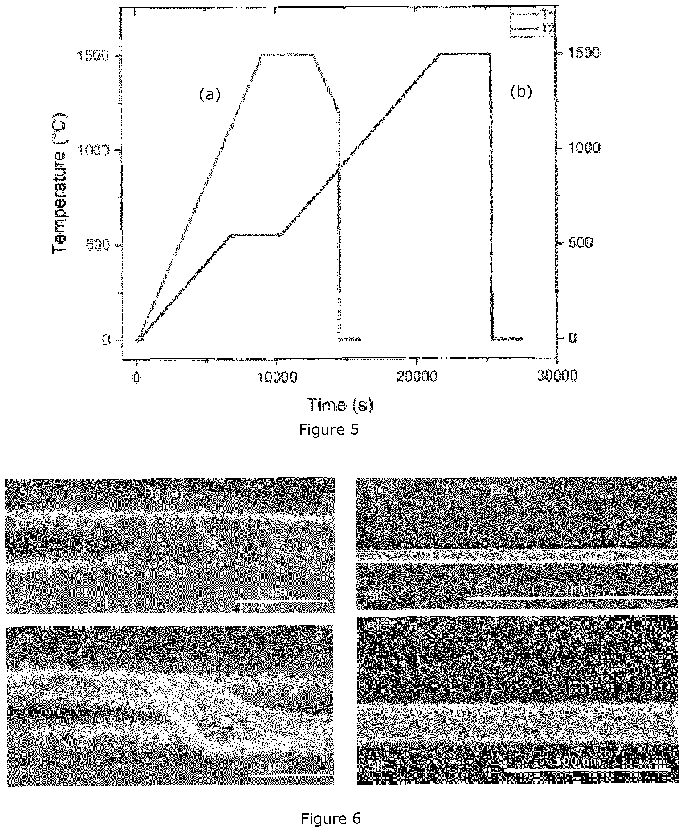

Polycarbosilane is mixed with m-xylene and AIBN, and then spin-coated onto a monocrystalline 4H-SiC substrate (3000 rpm, 40 s). A silicon carbide substrate is placed on top of the spin-coated film, and the assembly is pre-bonded under application of a constant force of about 350 N. The pre-bonded sample is heated according to temperature profile (b) in Figure 5 with a 5 °C/min temperature ramp with a 1 hour intermediate step at 550 °C to facilitate bonding. Finally, the structure is annealed at 1550 °C at 20 mbar back chamber pressure and with Ar atmosphere in a high-temperature furnace from HTM Reetz, resulting in a bonded sample.

Effusion measurements under high vacuum conditions reveal ionized moieties which can be associated with the rearrangements, condensation, and radical reactions that form new bonds, resulting from the adhesive bonding layer curing at temperatures up to 900 °C.

Fig. 6(b) shows a cross-sectional SEM image of the obtained bonded monocrystalline 4H-SiC substrate having a uniform bonded area with no visible defects or voids. The absence of defects may be explained by the gradual outgassing enabled by the reduced ramp rate, allowing material reorganization. Importantly, the bonding layer proved to be applied uniformly with a thickness ranging from 200 to 300 nm.

### COMPARATIVE EXAMPLE

The procedure of Example 1 is repeated, whereby the pre-bonded sample is heated according to temperature profile (a) in Figure 5 with a 10 °C/min temperature ramp and without an intermediate step.

Figure 6(a) shows the cross-sectional SEM image of the obtained bonded monocrystalline 4H-SiC substrate. The cross-section of the bonded sample reveals several defects like voids and disbonded areas, which may be resulting from the outgassing of compounds during the annealing process. Also, it was observed that the thickness of the bonding layer varied widely between 300 and 870 nm, while also the appearance of voids and defects was widely non-uniform.

## Claims

1. Process for preparing a compound semiconductor layered structure, comprising the steps of:
i. forming a layered structure (1, pre-3, 2) comprising a silicon carbide substrate (1), a silicon carbide film (2) and a bonding film (pre-3) connecting said silicon carbide substrate (1) and said silicon carbide film (2), whereby said bonding film (pre-3) comprises a ceramic-forming polymer precursor and a radical initiator;
ii. curing said ceramic-forming polymer precursor by heating said layered structure (1, pre-3, 2) at a curing temperature between 100°C and 700°C, thereby forming a cured layered structure (1, 3, 2); and subsequently
iii. annealing said cured layered structure (1, 3, 2) at an annealing temperature between 1180°C and 1800°C, thereby obtaining a compound semiconductor layered structure;
**characterised in that** said layered structure (1, pre-3, 2) is heated in step ii. from a temperature below 200°C to the curing temperature at a heating rate lower than 10°C per minute.

2. Process according to claim 1, whereby said curing step ii. comprises step ii.(a) whereby said layered structure (1, pre-3, 2) is heated in step ii. from a temperature below 200°C to the curing temperature at a heating rate lower than 10°C per minute; and step ii.(b), subsequent to step ii.(a), whereby the cured layered structure (1, 3, 2) is kept at a substantially constant temperature for a period of at least 1 minute.

3. Process according to claim 1 or 2, whereby said layered structure (1, pre-3, 2) is heated in step iii. from the curing temperature to 1000°C at a rate lower than 10°C per minute.

4. Process according to any of claims 1 to 3, whereby said bonding film (pre-3) is spin-coated onto a silicon carbide substrate (1) prior to step i., whereby said spin-coated bonding film (pre-3) is provided with a thickness of 50 nm to 1000 nm, as determined by SEM.

5. Process according to any of claims 1 to 4, whereby said layered structure (1, pre-3, 2) is pre-bonded prior to step ii. by applying a bonding force of 50 N to 1000 N for a period of at least 1 minute at a temperature above 100°C.

6. Process according to any of claims 1 to 5, whereby said silicon carbide film (2) is obtained by exfoliation of a silicon carbide film (2) from a monocrystalline silicon carbide wafer by electrochemical porosification.

7. Process according to claim 6, whereby prior to step i. said silicon carbide film (2) is subjected to a heat treatment at a temperature 1250°C and 1750°C under an inert atmosphere.

8. Process according to any of claims 1 to 7, wherein said ceramic-forming polymer precursor is cured in presence of a nitrogen containing radical initiator.

9. Process according to any of claims 1 to 8, whereby said ceramic-forming polymer precursor comprises a polycarbosilane, preferably a vinyl group containing polycarbosilane.

10. Process according to any of claims 1 to 9, whereby said porous core (22) of said silicon carbide film (2) has a porosity of 5% to 25%, as determined by cross-sectional SEM image analysis.

11. Process according to any of claims 1 to 10, whereby said silicon carbide semiconductor substrate (1) comprises a polycrystalline material.

12. Process according to any of claims 1 to 11, whereby said bottom layer (21) of said silicon carbide film (2) is provided with a thickness of at least 10 nm and at most 250 nm.

13. A silicon carbide semiconductor layered structure, comprising:
i. a silicon carbide substrate (1) having a bottom surface and a top surface;
ii. a silicon carbide film (2), said silicon carbide film (2) having a bottom layer (21), a porous core (22) and a top layer (23);
iii. a silicon carbide bonding layer (3), on a first side in direct contact with said silicon carbide substrate (1), and on a second side, opposite of the first side, in direct contact with said the bottom layer (21) of said silicon carbide film (2);
**characterized in that** said silicon carbide bonding layer (3) is free of voids having an average diameter larger than 10 nm, as determined by SEM.

14. Silicon carbide semiconductor layered structure according to claim 14, whereby said silicon carbide bonding layer (3) comprises nanocrystalline β-SiC.

15. Silicon carbide semiconductor layered structure according to claim 13 or 14, whereby said silicon carbide bonding layer (3) has a thickness of 50 nm to 1000 nm, as determined by SEM.
